# DEMANDE DE BREVET EUROPEEN

(11) **EP 4 831 751 A2**
(43) Date de publication de la demande: **28.10.2026**
(21) Numéro de dépôt: 26205151.9
(22) Date de dépôt: 08.07.2013
(51) Int. Cl.: G04B 17/06

(54) **PROCÉDÉ DE TRAITEMENT D'UNE SURFACE D'UN COMPOSANT HORLOGER ET COMPOSANT HORLOGER OBTENU PAR UN TEL PROCÉDÉ**

(30) Priorité: 06.07.2012 EP 12175240
(62) Numéro(s) de document de la (des) demande(s) initiale(s) en application de l'article 76 CBE: 24194470.1 / 4 439 193; 13734432.1 / 2 870 512
(71) Demandeur: ROLEX SA, 1211 Genève 26 (CH)
(72) Inventeur: TOBENAS BORRON, Susana del Carmen, 2555 Brugg (CH)
(74) Mandataire: Moinas & Savoye SARL

(57) **Abrégé**

Procédé de traitement d'une surface (2) d'une base (1) d'un composant horloger (10) en silicium ou en silicium recouvert de SiO₂, notamment d'un ressort spiral, le procédé comprenant :
- une première étape de dépôt d'une première couche (41) d'un premier oxyde; et

- une deuxième étape de dépôt d'une deuxième couche (51) d'un deuxième oxyde.

## Description

L'invention concerne un procédé de traitement d'une surface d'un composant horloger, notamment d'un ressort spiral, en particulier un spiral autocompensateur. Elle concerne aussi un composant horloger, notamment un ressort spiral, obtenu par un tel procédé. Elle concerne notamment un tel composant horloger en lui-même. Elle concerne enfin un mouvement horloger ou une pièce d'horlogerie, notamment une montre, comprenant un tel composant horloger.

L'existence de phénomènes de dérive de la fréquence d'un oscillateur balancier-spiral en fonction du temps est bien connue des horlogers. C'est ainsi qu'un oscillateur muni d'un spiral en alliage ferromagnétique brut de fabrication peut voir sa fréquence progressivement augmenter pour atteindre une variation de marche de l'ordre de 10 s/j au bout d'un an. Afin de réduire cette dérive, on effectue habituellement des traitements thermiques, appelés traitements d'étuvage, qui permettent de réduire la dérive de marche au cours des premières années au-dessous de 1 s/j, ce qui est acceptable, compte tenu des autres perturbations dues au porter de la montre, comme les chocs.

On constate le même phénomène de dérive dans le cas de spiraux en alliages paramagnétiques, notamment en alliage NbZr, comme relaté dans le brevet EP1039352. Contrairement à ce qui se passe pour les spiraux en alliages ferromagnétiques, le même type de traitement d'étuvage ne permet pas de réduire la dérive de marche au-dessous d'environ 5 s/j au bout d'un an dans le cas d'un spiral en alliage paramagnétique. La solution proposée par le brevet EP1039352 est de faire croître une couche d'oxyde d'alliage à la surface du spiral, notamment par un procédé d'anodisation. Ce procédé a l'avantage de former une couche d'oxyde à basse température, sans modifier la structure cristalline du spiral, d'épaisseur (et donc de couleur) parfaitement reproductible. Cependant, le procédé d'anodisation comporte certains inconvénients. En effet, il se déroule en phase liquide, nécessite l'établissement d'un contact électrique entre une électrode et le spiral, ne peut pas être sans autre transposé sur d'autres types de spiraux comme les spiraux en alliage Nivarox ou en Silicium, et ne peut que difficilement être effectué sur un spiral avec virole et/ou piton assemblé.

Dans le document CH702353, il est prévu de revêtir un spiral pour résoudre une problématique toute différente de celle de l'invention, à savoir celle de la stabilité en fréquence de l'oscillateur ou du résonateur balancier-spiral lorsque la température varie, ce qui implique de pouvoir contrôler précisément le coefficient thermoélastique du spiral. Il est notamment prévu un revêtement composé d'une couche en dioxyde de silicium et d'une couche en dioxyde de germanium sur une âme en silicium. L'âme et le revêtement présentent pour ce faire des coefficients thermoélastiques de signes opposés. Le revêtement présente un coefficient thermoélastique positif. Par ailleurs, dans ce document, aucune indication n'est donnée quant au procédé ou à la technique permettant d'obtenir de tels revêtements.

Le but de l'invention est de fournir un procédé de traitement de surface d'un composant horloger permettant de remédier aux inconvénients mentionnés précédemment et d'améliorer les procédés connus de l'art antérieur. En particulier, l'invention propose un procédé de traitement de surface permettant d'améliorer les performances d'un composant horloger, notamment d'augmenter les performances d'un ressort spiral, en particulier d'augmenter la stabilité en fréquence d'un oscillateur balancier-spiral muni d'un tel ressort au fil du temps.

L'invention est précisément définie par les revendications.

Les dessins annexés représentent, à titre d'exemples, différents modes d'exécution d'un procédé selon l'invention et différents modes de réalisation d'un composant horloger selon l'invention.
La figure 1 est une vue en coupe partielle d'un composant horloger obtenu en mettant en œuvre un premier mode d'exécution de l'invention.
La figure 2 est un diagramme illustrant les évolutions de la marche moyenne de mouvements horlogers en fonction du temps, pour deux lots de mouvements comprenant respectivement des spiraux traités selon le procédé objet de l'invention et des spiraux traités selon un procédé de l'art antérieur.
La figure 3 est un diagramme illustrant la palette des couleurs que l'on peut obtenir en déposant plusieurs couches d'oxyde sur un substrat en alliage NbZr.
La figure 4 est un diagramme illustrant la palette des couleurs que l'on peut obtenir en déposant plusieurs couches d'oxyde de même épaisseur sur un substrat en alliage NbZr.
La figure 5 est un diagramme illustrant la palette des couleurs que l'on peut obtenir en déposant plusieurs couches d'oxyde sur un substrat en alliage NbZr.
La figure 6 est un diagramme illustrant la palette des couleurs que l'on peut obtenir en déposant plusieurs couches d'oxyde sur un substrat en alliage FeNiCr.
La figure 7 est un diagramme illustrant la palette des couleurs que l'on peut obtenir en déposant plusieurs couches d'oxyde sur un substrat en silicium revêtu d'une couche d'oxyde de silicium.

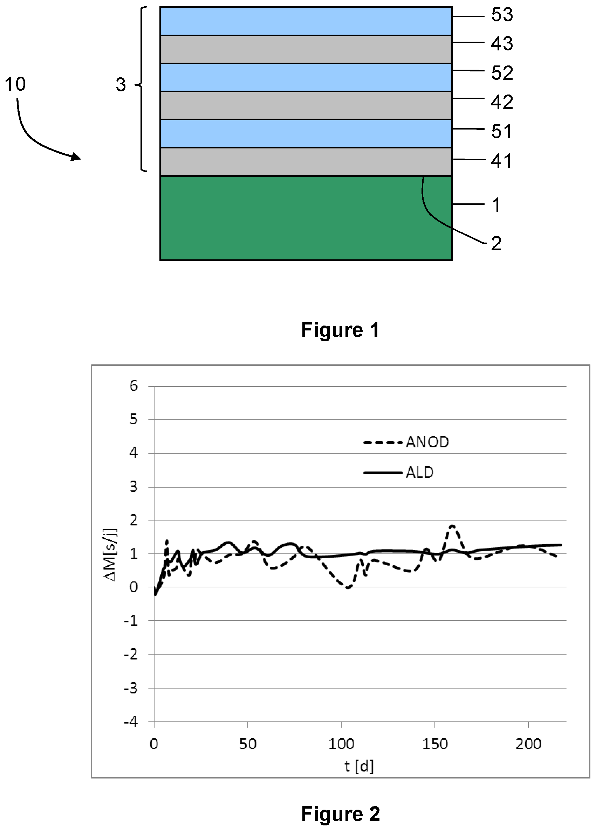

Dans un premier mode d'exécution du procédé de traitement de surface, on traite la surface 2 d'une base 1 (ou d'un substrat) d'un composant horloger 10 (représenté à la figure 1), en particulier on traite la surface d'une base d'un ressort spiral. La base du composant horloger peut être réalisée en alliage NbZr.

Dans une première étape, on dépose une première couche 41 d'un premier oxyde, par exemple l'oxyde Al₂O₃, puis dans une deuxième étape, on dépose une deuxième couche 51 d'un deuxième oxyde, par exemple l'oxyde TiO₂.

De préférence, on répète successivement plusieurs phases, notamment 2 ou 3 ou 4 phases, incluant chacune la première étape et la deuxième étape. Dans le premier mode d'exécution, une succession de trois phases est mise en œuvre.

En mettant en œuvre ce mode d'exécution, on obtient un revêtement 3 multicouche ou composé de plusieurs couches 41, 51, 42, 52, 43, 53 alternées des oxydes Al₂O₃ et TiO₂. Ce revêtement est représenté à la figure 1. De préférence, ce revêtement recouvre intégralement la surface du composant horloger. Ce revêtement appliqué sur un ressort spiral, par exemple avec une épaisseur de 11 nm pour chaque couche, donne d'excellents résultats en termes de stabilité de marche de l'oscillateur dont il fait partie. Ce revêtement présente également la particularité d'être perçu d'une couleur bleu profond.

Pour la réalisation d'un tel revêtement, on utilise de préférence une technologie de dépôt ALD (pour Atomic Layer Deposition). Un ou plusieurs ressorts 1 à traiter sont disposés sur des supports métalliques (par exemple en inox ou en aluminium) ou sur des supports en plastique résistant à la température nécessaire au dépôt (maximum 200°C) et convenant au travail sous vide. De tels supports plastique sont par exemple en PEEK (polyétheréthercétone) ou en PPS (Polyphenylene sulphide). Les supports qui maintiennent le spiral ou les spiraux sont ensuite placés à l'intérieur d'un réacteur ALD.

Une fois la température de dépôt atteinte à l'intérieur du réacteur chargé, on réalise une exposition alternée du spiral ou des spiraux à des précurseurs chimiques. Le dépôt se fait préférentiellement sous flux continu de diazote N₂, par exemple environ 20 sccm (standard cubic centimeter per minute) et/ou par exemple sous une pression d'environ 20 Pa. Dans la première étape, le substrat, c'est-à-dire notamment les spiraux, est exposé de manière séquentielle ou alternée à des vapeurs de trimethylaluminium (TMA) et d'eau (H₂O) pour former (par couches partielles successives) une couche d'oxyde Al₂O₃, par exemple d'une épaisseur de 0.11 nm par cycle d'exposition. Puis, dans une deuxième étape, les spiraux sont exposés de manière séquentielle ou alternée à des vapeurs de Tetrakis(dimethylamido)titanium (TDMAT) et d'eau (H₂O) pour former (par couches partielles successives) une couche d'oxyde TiO₂ avec une vitesse de dépôt de 0.045 nm par cycle d'exposition.

La pression de base dans la chambre, atteinte quand aucun précurseur ou flux de gaz n'est présent peut dépendre des caractéristiques de la chambre à vide et des pompes et peut par exemple, être inférieure ou égale à 0.1 Torr (<20 Pa), préférablement inférieure à 0.01 Torr (<2 Pa).

Par exemple, la pression dans la chambre atteinte sous flux de diazote, est typiquement de 20 Pa, avec une fenêtre de travail entre 10 Pa et 50 Pa. La pression peut dépendre de la chambre de dépôt, de la nature et de la surface des composants à revêtir.

Des dépôts comme ceux représentés à la figure 1 ont été effectués à 100, 120, 140, 200 et 280°C. D'un point de vue de la stabilité de la marche, les dépôts réalisés entre 100°C et 280°C sont satisfaisants, car ils permettent une stabilisation adéquate de la marche. La température de 280°C est élevée : elle présente un risque de dégradation des précurseurs chimiques utilisés. Une température de dépôt comprise entre 100°C et 200°C semble donc constituer un bon compromis.

Ainsi, on met en œuvre une technologie de dépôt ALD (pour Atomic Layer Deposition) pour déposer les première et deuxième couches, c'est-à-dire une technique de dépôt de couches minces particulière qui permet d'obtenir des couches et multicouches d'épaisseur nanométrique sur une grande variété de substrats. Contrairement à des techniques de déposition en phase vapeur (PVD) ou chimique (CVD), la formation des couches se fait directement à la surface du substrat, par une réaction entre (au moins) deux précurseurs chimiques qui sont introduits séquentiellement et séparément dans une chambre de dépôt. Cette chambre de dépôt ou réacteur ALD permet d'atteindre une pression de base inférieure à 20 Pa, plus préférablement inférieure à 2 Pa (avec les unités utilisées en général par les spécialistes de la technique, la pression est préférablement inférieure ou égale à 0.01 Torr).

Un « cycle » de dépôt comporte ainsi l'introduction d'un premier précurseur dans la chambre sous forme gazeuse pendant un temps donné, à un débit donné (contrôlé en général par la durée d'introduction du gaz ou durée du « pulse » et par la pression de vapeur du gaz, elle-même contrôlée par la température). Pour former de l'alumine Al₂O₃, ce premier précurseur est par exemple du TMA (triméthylaluminium), porté par un gaz porteur qui est en général du diazote. Une faible partie du premier précurseur se dépose à la surface du substrat (et des parois de la chambre) et réagit chimiquement avec les terminaisons -OH⁻ présentes sur la surface à revêtir, alors que le solde est évacué par des pompes à vide.

Un deuxième précurseur est ensuite introduit, par exemple de l'eau sous forme de vapeur d'eau, qui va réagir avec le premier précurseur adsorbé sur la surface pour former de l'alumine. L'épaisseur de la couche formée lors d'un cycle de dépôt va dépendre du matériau déposé, et est typiquement de 0.11 nm pour l'Al₂O₃. On répète ensuite les cycles jusqu'à obtention de l'épaisseur de couche désirée pour le matériau donné.

Les multicouches sont réalisées en modifiant la nature des précurseurs, et en particulier la nature du premier précurseur. Avec du TDMAT (Tetrakis(dimethylamido)titanium) comme premier précurseur en combinaison avec de l'eau comme deuxième précurseur, on obtient ainsi du TiO₂ à raison de typiquement 0.044 nm par cycle. Avec d'autres précurseurs, il est possible d'obtenir d'autres oxydes comme ZrO₂, HfO₂ ou ZnO par exemple.

Une couche d'oxyde, par exemple une couche d'oxyde natif, comporte en général des terminaisons -OH en surface qui facilitent le dépôt. Alternativement, la surface peut être oxydée avant dépôt ou l'ordre d'introduction des précurseurs peut être inversé. Les doses de précurseurs introduites dans la chambre dépendent des caractéristiques de la chambre de dépôt, de la nature et de la surface des pièces à revêtir. La pression atteinte sous flux de diazote, qui peut être continue ou non, est typiquement 20 Pa, avec une fenêtre de travail située en général entre 10 et 50 Pa, et va aussi dépendre de la chambre de dépôt.

Le procédé de dépôt ALD permet ainsi de déposer des couches céramiques (oxydes, nitrures et carbures) d'épaisseurs très faibles, extrêmement uniformes et parfaitement contrôlées à l'échelle sub-nanométrique. Ceci permet de revêtir des surfaces en trois dimensions qui sont irrégulières et très complexes du point de vue géométrique qui seraient difficiles à revêtir par d'autres technologies de dépôt de couches minces.

De façon surprenante, il a été constaté la présence sur un ressort spiral d'un revêtement obtenu par des couches réalisées par des dépôts selon une technologie ALD également sur les parties du spiral en contact avec le support. Par ailleurs, la qualité (uniformité de l'épaisseur et de la couleur) sur ces parties ne diffère pas de celles des parties du spiral directement exposées. Ceci a pour conséquence de faciliter grandement la réalisation des supports et la mise en œuvre du procédé de traitement, et de minimiser les manipulations à effectuer sur les composants à traiter ou revêtir. Si ce n'était pas le cas, il aurait fallu éviter tout contact entre les surfaces à revêtir et le support. Les contraintes de mise en œuvre du procédé auraient donc été nettement plus conséquentes.

Notons qu'un traitement thermique réalisé après la mise en œuvre du procédé de traitement, soit sous Formiergas, soit sous diazote, à par exemple 150 ou 200°C, ne dégrade pas la stabilité de la marche des spiraux.

La figure 2 illustre les évolutions de la marche moyenne de mouvements horlogers en fonction du temps, pour deux lots de mouvements. Les deux lots de mouvements sont équipés de spiraux en alliage NbZr. Un premier lot présente des spiraux anodisés, par exemple traités selon le procédé du document EP1039352. Les évolutions de la marche de ces mouvements sont représentées par une courbe référencée « ANOD ». Un deuxième lot présente des spiraux traités selon le premier mode d'exécution du procédé de traitement. Les évolutions de la marche de ces mouvements sont représentées par une courbe référencée « ALD ». On constate une légère dérive pendant les premiers jours de fonctionnement, de moins de 1 seconde par jour. La marche est ensuite tout-à-fait stable au cours du temps sur la durée de l'essai. Les résultats obtenus avec des spiraux traités selon l'invention est tout-à-fait comparable à ceux obtenus avec des spiraux traités par anodisation selon le document EP1039352.

Dans les différents modes d'exécution du procédé, la première couche et/ou la deuxième couche peut présenter une épaisseur nanométrique, c'est-à-dire d'une épaisseur de quelques nanomètres, par exemple de moins de 100 nm, en particulier de moins de 60 nm, plus particulièrement de moins de 20 nm. Par exemple, l'épaisseur de la première couche est comprise entre 2 nm et 15 nm, de préférence entre 3 nm et 12 nm et/ou l'épaisseur de la deuxième couche est comprise entre 2 nm et 15 nm, de préférence entre 3 nm et 12 nm.

Dans les différents modes d'exécution du procédé, l'épaisseur totale du revêtement 3 est préférentiellement choisie entre 10 et 300 nm, plus préférentiellement choisie entre 10 nm et 150 nm, encore plus préférentiellement entre 10 nm et 80 nm, afin de pouvoir garantir l'efficacité du dépôt et de ne pas dégrader les propriétés du composant et/ou du dépôt.

L'épaisseur maximale est fixée de façon à minimiser le risque de fissuration du revêtement à cause des contraintes résiduelles crées à l'interface substrat - revêtement lors du dépôt. Ce point est important pour des composants comme les spiraux d'horlogerie qui sont sollicités mécaniquement en traction/compression ou en flexion. De plus, plus le revêtement déposé est fin, moins les propriétés mécaniques des spiraux sont modifiées.

Divers essais ont été menés pour différents revêtements multi-couches déposées selon le procédé sur un substrat en alliage NbZr en variant l'épaisseur des couches, avec les résultats du tableau suivant :

| Structure | Couleur | épaisseur totale | stabilité de la marche |
|---|---|---|---|
| 2 bicouches (3nm Al₂O₃ / 3nm TiO₂) | Gris | 12nm | bonne |
| 3 bicouches (5nm Al₂O₃ / 5nm TiO₂) | Ocre | 30nm | très bonne |
| 3 bicouches (9nm Al₂O₃ / 9nm TiO₂) | Bleu | 54nm | très bonne |
| 3 bicouches (11nm Al₂O₃ / 11nm TiO₂) | Bleu | 66nm | excellente |

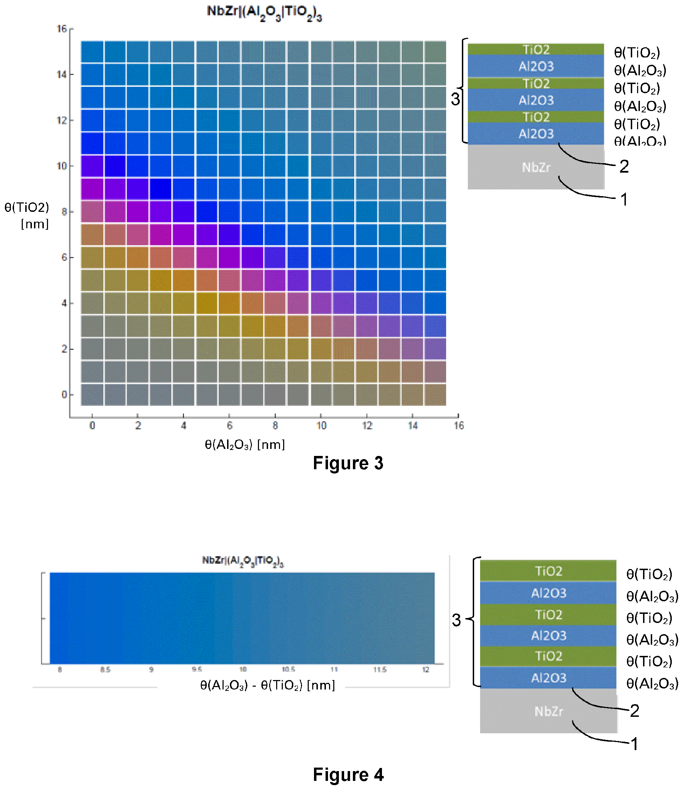

On voit donc que l'épaisseur de la couche d'oxyde a relativement peu d'importance pour atteindre une bonne stabilité de marche, de sorte que l'on peut choisir aussi cette épaisseur en fonction de la couleur désirée. C'est ainsi qu'avec les structures de couches utilisées, on peut aisément obtenir des couches de couleur bleu, mauve, fuchsia, orange, ocre, et gris-vert (voir figures 3 et 4). Comme il sera vu plus bas, en modifiant les matériaux utilisés, d'autres couleurs sont réalisables.

La figure 3 illustre la palette des couleurs que l'on peut obtenir en sélectionnant une première épaisseur des premières couches d'oxyde Al₂O₃ et une deuxième épaisseur des deuxièmes couches d'oxyde TiO_{2,} dans le cas de la mise en œuvre du procédé permettant de réaliser un revêtement incluant la superposition de 6 couches alternées d'oxydes sur un composant horloger comprenant une base ou un substrat en alliage NbZr. Toutes les couches d'Al₂O₃ ont la même épaisseur θ(Al₂O₃). Toutes les couches de TiO₂ ont la même épaisseur θ(TiO₂). Cette figure, ainsi que les figures suivantes, a été obtenue en calculant numériquement la distribution spectrale de la puissance lumineuse réfléchie par un échantillon illuminé en incidence normale par une source lumineuse dont la distribution spectrale est donnée par l'étalon colorimétrique D65. Cette distribution spectrale a ensuite été décomposée dans un espace colorimétrique donné, par exemple L*a*b*, afin de représenter l'aspect de l'échantillon.

La figure 4 illustre la palette des couleurs que l'on peut obtenir en sélectionnant une même épaisseur pour les premières couches d'oxyde Al₂O₃ et pour les deuxièmes couches d'oxyde TiO_{2,} dans le cas de la mise en œuvre du procédé permettant de réaliser un revêtement incluant la superposition de 6 couches alternées d'oxydes sur un composant horloger comprenant une base ou un substrat en alliage NbZr. Toutes les couches d'Al₂O₃ et toutes les couches de TiO₂ ont la même épaisseur θ.

L'épaisseur des différentes couches peut également être variée d'une couche à l'autre et d'un matériau à l'autre, sans effet technique discernable a priori (à part au niveau de la couleur apparente du revêtement). Si l'on souhaite obtenir un revêtement de couleur bleue du type comprenant n doubles couches (Al₂O₃|TiO₂) avec n compris entre 3 et 5, une optimisation mène à des solutions proches de celles exposées plus haut avec n=3 et une épaisseur de chaque couche de 11 nm. On peut aussi réduire l'épaisseur de chaque couche à 8.5 nm ou 9 nm et rester dans une couleur proche comme on peut le voir sur la figure 4. Cela étant, il faut aussi prendre en compte le fait que la formation du revêtement modifie les propriétés élastiques du spiral, en diminuant le coefficient thermique élastique apparent du spiral (d'environ 5ppm/°C pour les spiraux référencés « ALD » à la figure 2, ce qui correspond à une diminution du coefficient thermique de l'oscillateur balancier spiral de environ 0.2 s/j/°C) et en augmentant le couple. Il est donc nécessaire de tenir compte de ces différences lors du calcul de la forme du spiral et des divers traitements réalisés lors de la fabrication du spiral, de manière à obtenir le coefficient thermique élastique et le couple recherchés après le dépôt du revêtement par mise en œuvre du procédé objet de l'invention.

Des essais ont été menés avec des monocouches, notamment de Al₂O₃ ou de TiO₂. Dans la plupart des cas, la stabilité de marche obtenue n'est pas satisfaisante. La mise en œuvre d'une structure multicouche est beaucoup plus favorable qu'une seule couche, car elle permet d'obtenir une excellente stabilité de marche avec une épaisseur de couche raisonnable.

D'autres combinaisons de matériaux que (Al₂O₃|TiO₂) peuvent être envisagées pour obtenir une bonne stabilité de marche de spiraux d'horlogerie.

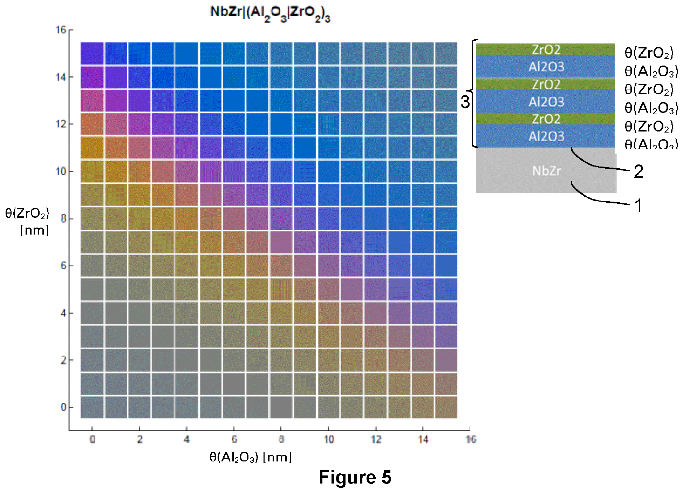

On peut ainsi utiliser d'autres oxydes métalliques, en particulier l'oxyde ZrO₂, et/ou combiner des couches de différents oxydes, en vue d'optimiser des revêtements multicouches de 6 couches ou plus. On peut ainsi envisager d'utiliser des revêtements du type à n doubles couches (Al₂O₃|ZrO₂) (voir figure 5), du type à n doubles couches (TiO₂|ZrO₂), voire d'autres combinaisons entre Al₂O₃, ZrO₂, TiO₂, HfO₂, ZnO, à deux ou plus de deux matériaux.

La figure 5 illustre la palette des couleurs que l'on peut obtenir en sélectionnant une première épaisseur des premières couches d'oxyde Al₂O₃ et une deuxième épaisseur des deuxièmes couches d'oxyde ZrO_{2,} dans le cas de la mise en œuvre du procédé permettant de réaliser un revêtement incluant la superposition de 6 couches alternées d'oxydes sur un composant horloger comprenant une base ou un substrat en alliage NbZr. Toutes les couches d'Al₂O₃ ont la même épaisseur θ(Al₂O₃). Toutes les couches de ZrO₂ ont la même épaisseur θ(ZrO₂).

Dans le cas de dépôts multicouches, on note également qu'il est possible d'obtenir une couleur bleue, proche de la cible, même en cas de variations des épaisseurs des différentes couches. Couplée à la capacité de la technologie ALD de contrôler précisément l'épaisseur des couches et à la grande reproductibilité de la technologie ALD, ceci garantit la robustesse du procédé.

Les documents EP0886195, EP1039352 et EP1258786 mentionnent plusieurs alliages paramagnétiques aux propriétés adéquates pour réaliser des spiraux d'horlogerie, notamment des spiraux auto- compensateurs, c'est-à-dire avec une valeur adéquate du coefficient thermique élastique. On cite ainsi l'alliage paramagnétique Nb-Zr contenant entre 5% et 25% en poids de Zr et au moins 500 ppm en poids d'un agent dopant formé au moins en partie d'oxygène ; ou encore les alliages paramagnétiques à base de Nb, Ta, V ; ou encore les alliages à base d'au moins un élément du groupe Nb, V, Ta et un élément du groupe Ti, Zr, Hf, comme par exemple les alliages Nb-Hf avec de faibles proportions de Hf (notamment entre 2 et 4% at). Dans un autre mode d'exécution du procédé de traitement de surface, le procédé est donc appliqué sur un substrat en alliage de type NbZr ou en alliage à base de Nb ou de Ta ou de V ou en alliage à base d'au moins un élément du groupe Nb, V, Ta et un élément du groupe Ti, Zr, Hf, comme par exemple les alliages Nb-Hf avec de faibles proportions de Hf (notamment entre 2 et 4% at).

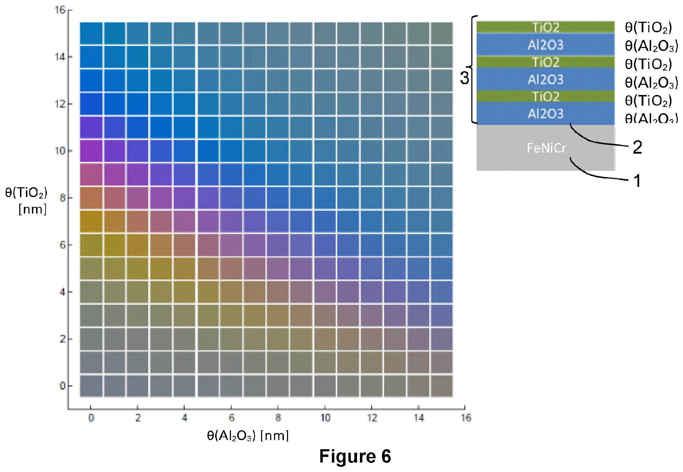

Les alliages ferromagnétiques à base de fer, nickel ou cobalt sont fréquemment utilisés pour la fabrication des spiraux (alliages « Nivarox » de type FeNiCr, par exemple). Des essais de dépôt ont été réalisés sur de tels spiraux : le dépôt et la stabilité de marche résultante sont tout-à-fait satisfaisants avec une structure de revêtement de 6 couches de type [(Al₂O₃|TiO₂)₃] avec des couches de 11 nm d'épaisseur. La couleur résultante de la couche était un bleu pâle dans ce cas, et peut être optimisée si désiré comme illustré à la figure 6. La figure 6 illustre la palette des couleurs que l'on peut obtenir en sélectionnant une première épaisseur des premières couches d'oxyde Al₂O₃ et une deuxième épaisseur des deuxièmes couches d'oxyde TiO_{2,} dans le cas de la mise en œuvre du procédé permettant de réaliser un revêtement incluant la superposition de 6 couches alternées d'oxydes sur un composant horloger comprenant une base ou un substrat en alliage FeNiCr. Toutes les couches d'Al₂O₃ ont la même épaisseur θ(Al₂O₃). Toutes les couches de TiO₂ ont la même épaisseur θ(TiO₂). Bien entendu, il est aussi envisageable de déposer une épaisseur de couche différente d'une couche à l'autre. Dans un autre mode d'exécution du procédé de traitement de surface, le procédé est donc appliqué sur un substrat en alliage de type FeNiCr.

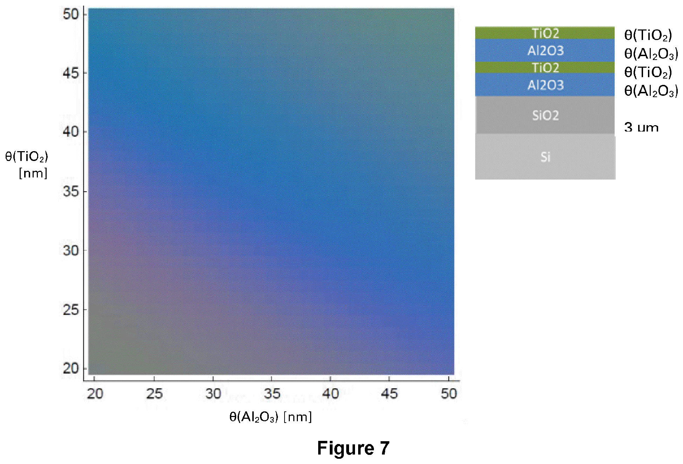

Le brevet EP1422436 décrit la réalisation de spiraux d'horlogerie en silicium Si avec un dépôt d'oxyde de silicium SiO₂ sur la périphérie pour réaliser la compensation thermique. La couche d'oxyde SiO₂ recouvrant le silicium peut avoir une épaisseur d'environ 3 µm. L'utilisation d'une technologie de dépôt ALD, par exemple d'un dépôt de type (Al₂O₃|TiO₂)ₙ, permet aussi d'obtenir une bonne stabilité de la marche au cours du temps. La couleur peut là aussi être ajustée avec l'épaisseur et les matériaux des couches comme illustré à la figure 7. La figure 7 illustre la palette des couleurs que l'on peut obtenir en sélectionnant une première épaisseur des premières couches d'oxyde Al₂O₃ et une deuxième épaisseur des deuxièmes couches d'oxyde TiO_{2,} dans le cas de la mise en œuvre du procédé permettant de réaliser un revêtement incluant la superposition de 4 couches alternées d'oxydes sur un composant horloger comprenant une base ou un substrat en Si revêtu d'une couche d'oxyde de silicium. Toutes les couches d'Al₂O₃ ont la même épaisseur θ(Al₂O₃). Toutes les couches de TiO₂ ont la même épaisseur θ(TiO₂). Des couches satisfaisantes ont ainsi été obtenues avec des couches alternées de 45 nm d'Al₂O₃ et de 50nm de TiO₂. Bien entendu, il est aussi envisageable de déposer une épaisseur de couche différente d'une couche à l'autre. Dans un autre mode d'exécution du procédé de traitement de surface, le procédé est donc appliqué sur un substrat en silicium ou en silicium revêtu d'un oxyde de silicium.

Dans les différents modes de réalisation, les différentes couches d'oxyde peuvent avoir des épaisseurs différentes, en particulier les différentes couches d'oxyde de même nature peuvent avoir des épaisseurs différentes.

Le procédé de traitement de surface selon l'invention présente de nombreux avantages :
- il permet de stabiliser la dérive de marche des spiraux d'horlogerie, notamment des spiraux réalisés en alliage paramagnétique comme le Nb-Zr ou en matériau diamagnétique comme le Si ;
- le dépôt ou revêtement est effectué à basse température sans influencer la structure cristalline du spiral ;
- il permet de régler avec une très grande simplicité et une très bonne reproductibilité l'épaisseur des couches déposées à la valeur désirée ;
- l'épaisseur de chaque couche et donc la couleur du spiral ainsi revêtu est très régulière ;
- il permet de réaliser des couches recouvrant chacune intégralement et régulièrement la base du composant horloger, même au niveau de surfaces en contact avec un support ;

Dans tout ce document, par « spiral » on entend le ressort spiral seul ou le ressort spiral et sa bride et/ou sa virole.

Dans le cadre de cette invention, plusieurs types de revêtements déposés par technologie ALD ont été réalisés dans le but de trouver un moyen alternatif à l'anodisation de l'alliage NbZr qui permette de réduire la dérive de marche de spiraux réalisés en NbZr au cours du temps. Il est possible d'obtenir des résultats équivalents à l'anodisation, voire meilleurs que l'anodisation, en mettant en œuvre le procédé de dépôt objet de l'invention pour déposer un revêtement d'oxyde en surface de spiraux d'horlogerie.

L'invention concerne aussi un composant horloger, notamment ressort spiral, obtenu par le procédé.

L'invention concerne donc un tel composant en lui-même.

Le composant comprend une base 10 et un revêtement 3 incluant une première couche 4 d'un premier oxyde et une deuxième couche 51 d'un deuxième oxyde.

La première couche et/ou la deuxième couche peuvent présenter une épaisseur nanométrique, c'est-à-dire une épaisseur inférieure à 100 nm.

La première couche et/ou la deuxième couche peuvent être déposées par une procédure de type dépôt ALD.

Le premier oxyde peut être ZrO₂ ou TiO₂ ou HfO₂ ou ZnO ou préférentiellement Al₂O₃. D'autres oxydes peuvent être également utilisés.

En cas d'utilisation d'un premier oxyde, le deuxième oxyde peut être différent du premier oxyde et peut être Al₂O₃ ou ZrO₂ ou HfO₂ ou ZnO ou préférentiellement TiO₂.

La base du composant horloger peut être en un alliage de type NbZr ou en silicium ou en silicium recouvert de SiO₂ ou en alliage de type FeNiCr. La base du composant horloger n'est cependant pas limitée à ces matériaux, mais peut être également en d'autres matériaux appropriés, comme du diamant ou du quartz.

La base du composant horloger peut être en un alliage à base de Nb ou de Ta ou de V.

Le revêtement peut comprendre plusieurs superpositions, notamment 2 ou 3 ou 4 superpositions, incluant chacune une première couche et une deuxième couche.

Le composant peut être tel que :
- l'épaisseur de la première couche est comprise entre 2 nm et 60 nm, de préférence entre 2 nm et 15 nm, de préférence entre 3nm et 12 nm, ou
- si la base du composant horloger est en un alliage de type NbZr ou en alliage de type FeNiCr, l'épaisseur de la première couche est comprise entre 2 nm et 15 nm, de préférence entre 3nm et 12 nm, ou
- si la base du composant horloger est en silicium ou en silicium recouvert de SiO₂, l'épaisseur de la première couche est comprise entre 3 nm et 60 nm, de préférence entre 20 nm et 60 nm, de préférence entre 40 nm et 60 nm.

Le composant peut être tel que :
- l'épaisseur de la deuxième couche est comprise entre 2 nm et 60 nm, de préférence entre 2 nm et 15 nm, de préférence entre 3nm et 12 nm, ou
- si la base du composant horloger est en un alliage de type NbZr ou en alliage de type FeNiCr, l'épaisseur de la deuxième couche est comprise entre 2 nm et 15 nm, de préférence entre 3nm et 12 nm, ou
- si la base du composant horloger est en silicium ou en silicium recouvert de SiO₂, l'épaisseur de la deuxième couche est comprise entre 3 nm et 60 nm, de préférence entre 20 nm et 60 nm, de préférence entre 40 nm et 60 nm.

Les couches peuvent recouvrir chacune intégralement la base du composant horloger.

La première et la deuxième couches sont de natures chimiques différentes.

Le premier oxyde, et/ou le deuxième oxyde, et/ou l'ensemble du premier oxyde et du deuxième oxyde sous forme de première couche et de deuxième couche, présentent avantageusement un coefficient thermoélastique négatif.

Ainsi, la base d'une part et au moins l'une des couches d'autre part présentent des coefficients thermoélastiques de signes opposés.

Par exemple, des spiraux en NbZr avec des couches selon l'invention montrent un coefficient thermoélastique inférieur à celui de spiraux issus du même lot de fabrication sans couche additionnelle (écart de coefficient thermique de l'oscillateur balancier spiral de -0.2 s/j/°C). De même, le coefficient thermoélastique de spiraux en Si/SiO2 avec des couches selon l'invention est très nettement inférieur à celui de spiraux issus du même lot de fabrication sans couche additionnelle (écart de coefficient thermique de l'oscillateur balancier spiral de -0.9 s/j/°C). Dans les deux cas, cela implique que le coefficient thermoélastique du premier et/ou du deuxième oxyde est fortement négatif, de même signe que celui du silicium par exemple. Dans l'hypothèse où le premier et le deuxième oxyde ont le même coefficient thermoélastique, on peut estimer ce coefficient thermoélastique à approximativement -500 ppm/°C. Il est donc nécessaire de tenir compte des matériaux et des épaisseurs des différentes couches lors du calcul de la forme du spiral et des divers traitements réalisés lors de la fabrication du spiral, afin d'obtenir un coefficient thermique élastique et un couple du spiral aptes à la réalisation d'un oscillateur ou résonateur balancier-spiral avec les bonnes propriétés de fréquence et de thermocompensation.

Dans une variante de réalisation, la première couche 41 est réalisée en un premier nitrure et/ou la deuxième couche 51 est réalisée en un deuxième nitrure. Il s'ensuit que les première et deuxième couches peuvent être des oxydes ou des nitrures ou respectivement un oxyde et un nitrure ou respectivement un nitrure et un oxyde.

Le premier nitrure peut être AlTiCN ou AlN ou TiN, mais d'autres nitrures peuvent également être utilisés.

En cas d'utilisation d'un premier nitrure, le deuxième nitrure est différent du premier nitrure et peut être AlTiCN ou AlN ou TiN.

Dans une autre variante de réalisation, la première couche 41 est réalisée en un premier carbure et/ou la deuxième couche 51 est réalisée en un deuxième carbure. Il s'ensuit que les première et deuxième couches peuvent être des oxydes ou des nitrures ou des carbures. Ainsi, les première et deuxième couches peuvent être :
- des oxydes, ou
- des nitrures, ou
- des carbures, ou
- respectivement un oxyde et un nitrure, ou
- respectivement un nitrure et un oxyde, ou
- respectivement un oxyde et un carbure, ou
- respectivement un carbure et un oxyde, ou
- respectivement un nitrure et un carbure, ou
- respectivement un carbure et un nitrure.

Le premier ou le deuxième carbure peut être par exemple AlTiCN.

Sauf incompatibilité logique ou technologique, toutes les caractéristiques de composant énoncées précédemment sont combinables entre elles.

L'invention porte encore sur un mouvement comprenant un composant horloger tel que défini précédemment.

L'invention porte aussi sur une pièce d'horlogerie, notamment une montre, comprenant un mouvement tel que défini précédemment ou un composant horloger tel que défini précédemment.

Finalement, l'invention porte aussi sur un procédé de traitement d'une surface 2 d'une base 1 d'un composant horloger 10, notamment d'un ressort spiral, le procédé comprenant :
- une première étape de dépôt d'une première couche 41 d'un premier oxyde ou d'un premier nitrure ou d'un premier carbure ; et
- une deuxième étape de dépôt d'une deuxième couche 51 d'un deuxième oxyde ou d'un deuxième nitrure ou d'un deuxième carbure.

Le procédé peut comprendre une première étape de dépôt d'une première couche 41 d'un premier oxyde et une deuxième étape de dépôt d'une deuxième couche 51 d'un deuxième oxyde.

De plus :
- le premier oxyde, et/ou
- le deuxième oxyde, et/ou
- l'ensemble du premier oxyde et du deuxième oxyde sous forme de première couche et de deuxième couche,
peuvent présenter un coefficient thermoélastique négatif.

La base d'une part et au moins l'un des couches d'autre part peuvent présenter des coefficients thermoélastiques de signes opposés.

Le premier oxyde peut être ZrO₂ ou TiO₂ ou HfO₂ ou ZnO ou préférentiellement Al₂O₃.

Le deuxième oxyde peut être différent du premier oxyde et être Al₂O₃ ou ZrO₂ ou HfO₂ ou ZnO ou préférentiellement TiO₂.

La base du composant horloger peut être en un alliage de type NbZr ou en silicium ou en silicium recouvert de SiO₂ ou en alliage de type FeNiCr.
- L'épaisseur de la première couche peut être comprise entre 2 nm et 60 nm, de préférence entre 2 nm et 15 nm, de préférence entre 3nm et 12 nm, ou
- avec la base du composant horloger en un alliage de type NbZr ou en alliage de type FeNiCr, l'épaisseur de la première couche peut être comprise entre 2 nm et 15 nm, de préférence entre 3nm et 12 nm, ou
- avec la base du composant horloger en silicium ou en silicium recouvert de SiO₂, l'épaisseur de la première couche peut être comprise entre 3 nm et 60 nm, de préférence entre 20 nm et 60 nm, de préférence entre 40 nm et 60 nm.
- L'épaisseur de la deuxième couche peut être comprise entre 2 nm et 60 nm, de préférence entre 2 nm et 15 nm, de préférence entre 3nm et 12 nm, ou
- avec la base du composant horloger en un alliage de type NbZr ou en alliage de type FeNiCr, l'épaisseur de la deuxième couche peut être comprise entre 2 nm et 15 nm, de préférence entre 3nm et 12 nm, ou
- avec la base du composant horloger en silicium ou en silicium recouvert de SiO₂, l'épaisseur de la deuxième couche peut être comprise entre 3 nm et 60 nm, de préférence entre 20 nm et 60 nm, de préférence entre 40 nm et 60 nm.

Le premier nitrure peut être AlTiCN ou AlN ou TiN.

Le deuxième nitrure peut être différent du premier nitrure et peut être AlTiCN ou AlN ou TiN.

La première couche et/ou la deuxième couche peuvent présenter une épaisseur nanométrique.

La première couche et/ou la deuxième couche peuvent être déposées par une procédure de type dépôt ALD.

Le procédé peut comprendre plusieurs phases, notamment 2 ou 3 ou 4 phases, incluant chacune la première étape et la deuxième étape.

La première étape et/ou la deuxième étape peuvent être réalisées à une température comprise entre 100°C et 280°C, en particulier comprise entre 100°C et 200°C.

Les couches peuvent recouvrir chacune intégralement la base du composant horloger.

L'invention porte aussi sur un composant horloger 10, en particulier ressort spiral, obtenu par la mise en œuvre du procédé tel que décrit précédemment.

L'invention porte aussi sur un mouvement comprenant un tel composant horloger.

L'invention porte aussi sur une pièce d'horlogerie, notamment montre, comprenant un tel mouvement ou un tel composant horloger.

L'invention porte aussi sur un composant horloger, notamment ressort spiral, caractérisé en ce qu'il comprend une base 1 et un revêtement 3 incluant :
- une première couche 41 d'un premier oxyde ou d'un premier nitrure ou d'un premier carbure ; et
- une deuxième couche 51 d'un deuxième oxyde ou d'un deuxième nitrure ou d'un deuxième carbure.

Le composant horloger, notamment un ressort spiral, peut comprendre une base 1 et un revêtement 3 incluant une première couche 41 d'un premier oxyde et une deuxième couche 51 d'un deuxième oxyde.

De plus :
- le premier oxyde, et/ou
- le deuxième oxyde, et/ou
- l'ensemble du premier oxyde et du deuxième oxyde sous forme de première couche et de deuxième couche,
peuvent présenter un coefficient thermoélastique négatif.

La base d'une part et au moins l'un des couches d'autre part peuvent présenter des coefficients thermoélastiques de signes opposés.

Le premier oxyde peut être ZrO₂ ou TiO₂ ou HfO₂ ou ZnO ou préférentiellement Al₂O₃.

Le deuxième oxyde peut être différent du premier oxyde et est Al₂O₃ ou ZrO₂ ou HfO₂ ou ZnO ou préférentiellement TiO₂.

La base du composant horloger peut être en un alliage de type NbZr ou en silicium ou en silicium recouvert de SiO₂ ou en alliage de type FeNiCr.

De plus :
- l'épaisseur de la première couche peut être comprise entre 2 nm et 60 nm, de préférence entre 2 nm et 15 nm, de préférence entre 3nm et 12 nm, ou
- si la base du composant horloger est en un alliage de type NbZr ou en alliage de type FeNiCr, l'épaisseur de la première couche peut être comprise entre 2 nm et 15 nm, de préférence entre 3nm et 12 nm, ou
- si la base du composant horloger est en silicium ou en silicium recouvert de SiO₂, l'épaisseur de la première couche peut être comprise entre 3 nm et 60 nm, de préférence entre 20 nm et 60 nm, de préférence entre 40 nm et 60 nm.

De plus :
- l'épaisseur de la deuxième couche peut être comprise entre 2 nm et 60 nm, de préférence entre 2 nm et 15 nm, de préférence entre 3nm et 12 nm, ou
- si la base du composant horloger est en un alliage de type NbZr ou en alliage de type FeNiCr, l'épaisseur de la deuxième couche peut être comprise entre 2 nm et 15 nm, de préférence entre 3nm et 12 nm, ou
- si la base du composant horloger est en silicium ou en silicium recouvert de SiO₂, l'épaisseur de la deuxième couche peut être comprise entre 3 nm et 60 nm, de préférence entre 20 nm et 60 nm, de préférence entre 40 nm et 60 nm.

Le premier nitrure peut être AlTiCN ou AlN ou TiN.

Le deuxième nitrure peut être différent du premier nitrure et peut être AlTiCN ou AlN ou TiN.

La première couche et/ou la deuxième couche peuvent présenter une épaisseur nanométrique.

La première couche et/ou la deuxième couche peuvent être déposées par une procédure de type dépôt ALD.

Le revêtement peut comprendre plusieurs superpositions, notamment 2 ou 3 ou 4 superpositions, incluant chacune une première couche, notamment une première couche d'un premier oxyde, et une deuxième couche, notamment une deuxième couche d'un deuxième oxyde.

Les couches peuvent recouvrir chacune intégralement la base du composant horloger.

L'invention porte aussi sur un mouvement comprenant un composant horloger tel que décrit ci-dessus.

L'invention porte aussi sur une pièce d'horlogerie, notamment une montre, comprenant un tel mouvement ou un composant horloger tel que décrit ci-dessus.

## Revendications

1. Procédé de traitement d'une surface (2) d'une base (1) d'un composant horloger (10) en silicium ou en silicium recouvert de SiO₂, notamment d'un ressort spiral, le procédé comprenant :
- une première étape de dépôt d'une première couche (41) d'un premier oxyde; et
- une deuxième étape de dépôt d'une deuxième couche (51) d'un deuxième oxyde.

2. Procédé selon la revendication précédente, **caractérisé en ce que** l'ensemble du premier oxyde et du deuxième oxyde sous forme de première couche et de deuxième couche présentent un coefficient thermoélastique négatif.

3. Procédé selon l'une des revendications précédentes, **caractérisé en ce que** la base d'une part et au moins l'un des couches d'autre part présentent des coefficients thermoélastiques de signes opposés.

4. Procédé selon l'une des revendications précédentes, **caractérisé en ce que** la première couche et/ou la deuxième couche sont déposées par une procédure de type dépôt ALD.

5. Procédé selon l'une des revendications précédentes, **caractérisé en ce qu'**il comprend plusieurs phases, notamment 2 ou 3 ou 4 phases, incluant chacune la première étape et la deuxième étape.

6. Procédé selon l'une des revendications précédentes, **caractérisé en ce que** la première étape et/ou la deuxième étape est réalisée à une température comprise entre 100°C et 280°C, en particulier comprise entre 100°C et 200°C.

7. Composant horloger, notamment ressort spiral, **caractérisé en ce qu'**il comprend une base (1) en silicium ou en silicium recouvert de SiO₂ et un revêtement (3) incluant :
- une première couche (41) d'un premier oxyde ; et
- une deuxième couche (51) d'un deuxième oxyde.

8. Composant selon la revendication précédente, **caractérisé en ce que** l'ensemble du premier oxyde et du deuxième oxyde sous forme de première couche et de deuxième couche présentent un coefficient thermoélastique négatif.

9. Composant selon l'une des revendications 7 ou 8, **caractérisé en ce que** la base d'une part et au moins l'un des couches d'autre part présentent des coefficients thermoélastiques de signes opposés.

10. Composant selon l'une des revendications 7 à 9, **caractérisé en ce que** le premier oxyde est ZrO₂ ou TiO₂ ou HfO₂ ou ZnO ou préférentiellement Al₂O₃
et/ou **caractérisé en ce que** le deuxième oxyde est différent du premier oxyde et est Al₂O₃ ou ZrO₂ ou HfO₂ ou ZnO ou préférentiellement TiO₂.

11. Composant selon l'une des revendications 7 à 10, **caractérisé en ce que** :
- l'épaisseur de la première couche est comprise entre 3 nm et 60 nm, de préférence entre 20 nm et 60 nm, de préférence entre 40 nm et 60 nm,
et/ou **en ce que** :
- l'épaisseur de la deuxième couche est comprise entre 3 nm et 60 nm, de préférence entre 20 nm et 60 nm, de préférence entre 40 nm et 60 nm.

12. Composant selon l'une des revendications 7 à 11, **caractérisé en ce que** la première couche et/ou la deuxième couche présentent une épaisseur nanométrique.

13. Composant selon l'une des revendications 7 à 12, **caractérisé en ce que** le revêtement comprend plusieurs superpositions, notamment 2 ou 3 ou 4 superpositions, incluant chacune une première couche, notamment une première couche d'un premier oxyde, et une deuxième couche, notamment une deuxième couche d'un deuxième oxyde.

14. Composant selon l'une des revendications 7 à 13, **caractérisé en ce que** les couches recouvrent chacune intégralement la base du composant horloger.

15. Mouvement comprenant un composant horloger selon l'une des revendications 7 à 14.

16. Pièce d'horlogerie, notamment montre, comprenant un mouvement selon la revendication précédente ou un composant horloger selon l'une des revendications 7 à 14.
